# EUROPEAN PATENT APPLICATION

(11) **EP 1 936 807 A1**
(43) Date of publication of application: **25.06.2008**
(21) Application number: 06820014.6
(22) Date of filing: 05.10.2006
(51) Int. Cl.: H03K 17/96

(54) **DETECTION COMPONENT FOR A SENSORY TOUCH SCREEN**

(30) Priority: 14.10.2005 ES 200502504
(71) Applicant: MODULOS DIGITALES PARA EL LAVADO S.A., 08190-SANT CUGAT DEL VALLES (ES)
(72) Inventor: VALLS IZARD, Ramón María, (Barcelona) (ES)
(74) Representative: Curell Aguilà, Marcelino
(86) International application number: PCT/ES2006/000553
(87) International publication number: WO 2007/045703

(57) **Abstract**

Detection device for a tactile screen device suitable for detecting the close presence of a finger through a sheet of dielectric material (7). The component has a detection circuit that comprises a reference impedance (3) placed between a pulse generator (2) that provides an input voltage signal (S1) and an electrode (6) applied to the sheet of dielectric material (7), a voltage clamping circuit (4) and a envelope detection circuit (5) placed serially between the electrode (6) and a receiver (1). The output signal (S4) that reaches receiver (1) is a continuous voltage signal and its value varies in the presence of a finger on the sheet of dielectric material (7) opposite electrode (6).

## Description

### Field of the invention

The invention relates to a detection component for a tactile screen device, suitable for detecting the close presence of a finger through a sheet of dielectric material, of the type comprising a detection circuit that has an electrode applied to one side of said sheet of dielectric material, a generator that provides an input voltage signal and a receiver that receives an output voltage signal, the detection occurring because said electrode forms an equivalent capacitor and its capacitance varies when a finger is placed close to or applied to the other side of said sheet of dielectric material opposite the electrode, causing said output voltage signal to vary.

### State of the art

Tactile screens or keyboards, frequently known by the English expression "touch sensor", are made up of proximity detectors that can detect the presence of a user's finger on a sheet of dielectric material, such as for example a sheet of plastic, glass or ceramic insulating material. Advantageously, they are used on glass ceramic worktops, where the detectors combine with digital displays or luminous indicators availing of the transparency of the glass ceramic to form interactive controls.

A known method for detecting the presence of a finger on the outer surface of the sheet of insulating material consists in applying an electrode to the opposite side of said sheet, the dimensions and shape of said electrode varying according to the surface that it is desired to be sensitive, and measuring the capacitance between this electrode and ground. In fact, the presence of the finger applied via the sheet of dielectric material opposite the electrode significantly increases the ground capacitance of the equivalent capacitor formed by said electrode, the increase typically being comprised between fractions of picofarads and units of picofarads.

Various different solutions are known for detecting this small variation in capacitance. It is worth highlighting the solution proposed by US patent application US2001019228, that uses an a.c. voltage applied to a capacitive divider and a PNP transistor as amplifier. However, the known solutions are based on fairly complicated and cumbersome circuits, which require relatively high operating voltages, typically 24V.

### Summary of the invention

The aim of the invention is to provide a detection system based on a simpler, more effective component than the state of the art. This aim is achieved by means of a component of the type indicated at the beginning, characterised in that said generator is a pulse generator, with said input voltage signal being a pulse signal, and said detection circuit comprising:
- a reference impedance placed between said pulse generator and said electrode, so that an attenuated pulse signal is obtained in said electrode having the same frequency as the input voltage signal, but attenuated according to a time constant that depends on the value of said variable capacitance of the equivalent capacitor formed by the electrode;
- a voltage clamping circuit and an envelope detection circuit arranged serially between said electrode and said receiver, so that said voltage clamping circuit receives said attenuated voltage signal and shifts it in voltage to provide a referenced voltage signal, and said envelope detection circuit receives said referenced voltage signal and provides said output voltage signal, which is virtually a continuous voltage signal with a value corresponding to the peak voltage of said referenced voltage signal.

The advantages of the component according to the invention are minimum cost and complexity, very low current consumption, minimum radioelectric field emission and optimum time and temperature stability since no signal amplifier is required. Also, because of the type of input and output voltage signals, the component according to the invention can be controlled optimally by means of a microcontroller that has an analogue/digital converter.

The voltage clamping circuit and the envelope detection circuit must be understood, preferably, to be those known as basic diode applications. These circuits are described in basic electronic manuals. Alternatively, more sophisticated circuits can be applied, which perform an equivalent function, such as for example circuits based on operational amplifiers, but solutions of this type unnecessarily increase the cost of the component.

The invention contemplates some advantageous embodiments of said voltage clamping circuit and envelope detection circuit. Preferably, said voltage clamping circuit is made up of a first capacitor connected to said electrode and a first diode connected by its cathode to said first capacitor and by its anode to the zero level of said input voltage signal, with said referenced voltage signal being obtained in the cathode of said first diode. Also, preferably, said envelope detection circuit is made up of a second diode connected by its anode to the output of said voltage clamping circuit that provides said referenced voltage signal, a second capacitor and a second resistor assembled in parallel and connected on one side to the cathode of said second diode and on the other side to the zero level of said input voltage signal, with said output voltage signal being obtained in the cathode of said second diode.

These embodiments correspond to solutions according to a negative ground layout. Alternatively, the invention also contemplates equivalent embodiments corresponding to solutions according to a positive ground layout. In this case, said voltage clamping circuit is made up of a first capacitor connected to said electrode that provides said attenuated voltage signal and a first diode connected by its anode to said first capacitor and by its cathode to the high level of said input voltage signal, said referenced voltage signal being obtained in the anode of said first diode. Also, preferably, said envelope detection circuit is made up of a second diode connected by its cathode to the output of said voltage clamping circuit that provides said referenced voltage signal, a second capacitor and a resistor assembled in parallel and connected on one side to the anode of said second diode and on the other side to the high level of said input voltage signal, said output voltage signal being obtained in the anode of said second diode.

Preferably, said reference impedance is a resistor. Alternatively, said reference impedance is a serial or parallel combination of various resistive, capacitive or inductive components.

Advantageously, said pulse generator that produces the input voltage signal is an output port of a microcontroller and said output voltage signal receiver is an input port of said microcontroller, so that the component can be fully controlled by a microcontroller.

In a preferred embodiment, said pulse generator is activated and deactivated cyclically, with the output voltage being measured in a synchronized manner, to that current consumption is reduced.

A very useful quality of the detection circuit according to the invention is that when the output of several detection circuits are connected in parallel, with the condition that only one of them is excited by a pulse signal, the output signal will be the one corresponding to said excited sensor, without, under any circumstances, the other outputs from non-excited circuits loading said signal. By virtue of this quality, the invention also contemplates solutions in which the component can act with several sensitive keys, in other words that it is suitable for detecting the close presence of a finger through a sheet of dielectric material in a plurality of different locations. A component of this type according to the invention is characterized in that it comprises a single pulse generator and a plurality of said detection circuits arranged in parallel and powered sequentially by said pulse generator. Preferably, each of said detection circuits comprises its own said second diode and shares said second capacitor and said second resistor with the other detection circuits, so that said second diode in each detection circuit performs multiplexing functions.

### Brief description of the drawings

Other advantages and characteristics of the invention will be appreciated from the following description which describes, in a non-limiting way, some preferred embodiments of the invention with reference to the accompanying drawings, which show:
Fig. 1, a schematic block diagram of a component according to the invention with a basic detection circuit;
Fig. 2, an electrical diagram showing the performance of the circuit in Fig .1, according to a negative ground layout;
Fig. 3, a representation of the voltage signals obtained on the various points of the circuit in Figs. 1 and 2, where a comparison is made between the signals obtained when the finger is distanced from the sensitive key (left) and when the finger is applied to said key (right);
Fig. 4, an electrical diagram showing an alternative embodiment of the circuit in Fig. 1;
Fig. 5, an electrical diagram of an embodiment in which the component according to the invention controls various sensitive keys.

### Detailed description of some embodiments of the invention

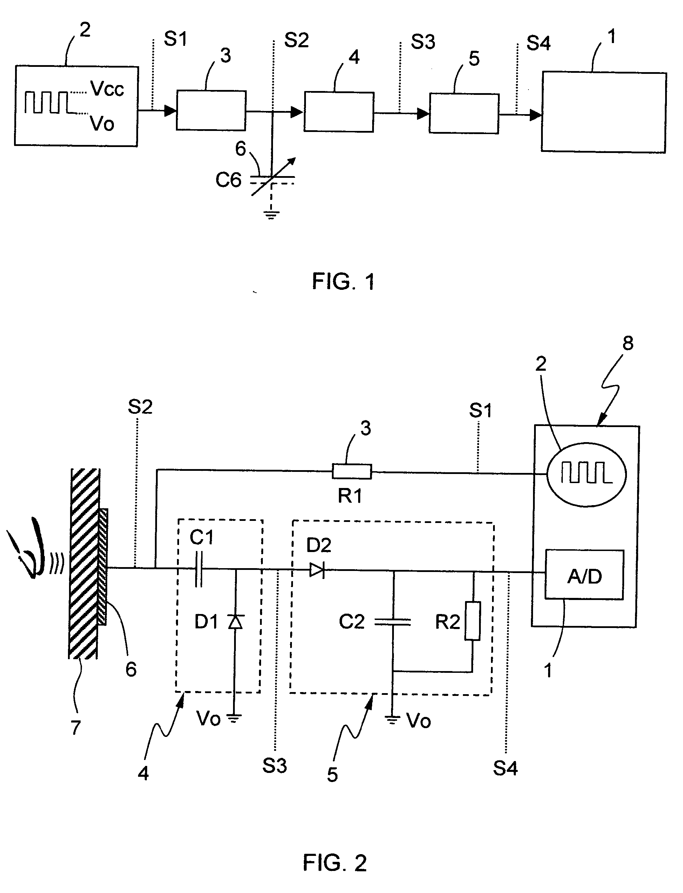

A first basic embodiment of the component according to the invention is illustrated in Figs. 1, 2 and 3. It is a component for detecting the presence of a finger on a sensitive key formed by an electrode 6 applied to the inside of an insulating sheet 7 formed by a kitchen glass ceramic plate.

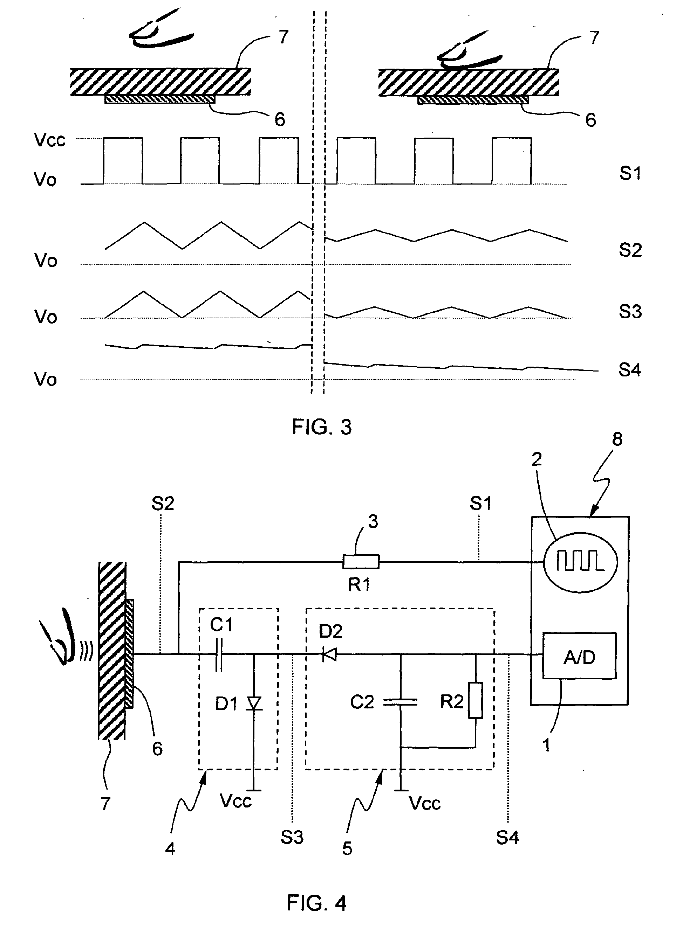

The operating principle of the detection circuit of the component is illustrated by the block diagram in Fig. 1 and by the representations of the voltage signals in Fig. 3. Fig. 2 shows a particular embodiment of this component.

A voltage pulse generator 2 injects into electrode 6 an input voltage signal S1, which in this case is a square shape pulse signal with a frequency of 500 kHz and a high Vcc level of 5 V. Electrode 6 is a conducting plate, which may or may not be metallic, supported on or adhered to insulating sheet 7, and it is connected to pulse generator 2 by means of reference impedance 3 which in this case is a R1 resistor with 47 kΩ. A voltage clamping circuit 4 and a envelope detection circuit 5 are placed serially between electrode 6 and an output signal receiver 1.

As can be seen in Fig. 2, voltage clamping circuit 4 is made up of a first capacitor C1 connected to electrode 6 and a first diode D1 connected by its cathode to said first capacitor C1 and by its anode to the zero level Vo of input voltage signal S1. The capacitance of capacitor C1 is small, in this case 10 pF, so capacitor C1 can couple the frequency of input signal S1 and decisively block low frequencies such as those in electrical network, which are 50 or 60 Hz. Envelope detector 5, for its part, is made up of a second diode D2 connected by its anode to the output of voltage clamping circuit 4 (in other words, in this case, to the cathode of the first diode D1), a second capacitor C2 and a second resistor R2 assembled in parallel and connected on one side to the cathode of said second diode D2 and on the other side to the zero level Vo of input voltage signal S1. In this case, second capacitor C2 has a capacitance of 1 nF and second resistor R2 has a value of 470 kΩ. So that the circuit is optimally sensitive, it is advisable that both diodes D1 and D2 have a sufficiently low parasitic capacitance, for example less than 1.5 pF. A suitable diode is BAL99. Preferably, both diodes D1 and D2 are encapsulated in a single tripolar component, such as BAV99. The detection circuit is controlled by a microcontroller 8 which, via one of its ports, behaves like a pulse generator 2 that provides input voltage signal S1, while via another one of its ports it behaves like detector 1 of output voltage signal S4.

The circuit power is ground connected directly or via a capacitor that has a sufficiently high capacitance, but if a ground connection is not available it can also be connected to neutral or to line voltage, which in the presence of a high frequency behave as such, or it can be left floating if the whole circuit is powered with a transformer that has sufficient parasitic capacitance.

The detection circuit works as described below.

Electrode 6 behaves like an equivalent capacitor C6 with a ground capacitance that depends on the presence in front of it, on the other side of insulating sheet 7, of the user's finger. Equivalent capacitor C6 and reference impedance 3 define an attenuator for input voltage signal S1 that has a time constant determined by the value (variable) of the capacitance of said equivalent capacitor C6 and the value (fixed) of said reference impedance 3. When an input voltage signal S1, formed by a train of pulses with sufficiently high frequency is applied to said attenuator, an attenuated voltage signal S2 is obtained in electrode 6, with the same frequency but smaller amplitude, as can be seen in Fig. 3. Preferably, the value of reference impedance 3 is chosen so that the attenuation is approximately 45-50% when the finger is absent from insulating sheet 7, thereby obtaining maximum sensitivity in this case.

Voltage clamping circuit 4 receives attenuated voltage signal S2 and maintains a referenced voltage signal S3 at its output, which has the same shape and amplitude as said attenuated signal S2, but where the lower peak has been shifted to the voltage level of the anode of first diode D1, which is the zero level Vo of input voltage signal S1. Peak detector circuit 5 charges second capacitor C2 until the upper peak voltage of the wave shape of said referenced voltage signal S3 is reached, and unloading via second resistor R2 with a sufficiently slow time constant, so that an output voltage signal is obtained which, in practice, can be considered to be a continuous voltage signal.

When a finger is placed on insulating sheet 7, opposite electrode 6, the ground capacitance of equivalent capacitor C6 increases, typically 20%. Consequently, there is a greater attenuation of input voltage signal S1, whereby attenuated signal S2 and referenced signal S3 lose amplitude and the value of output voltage signal S4, which is virtually a continuous voltage with an equivalent value to the amplitude of said referenced voltage signal S3, is reduced correspondingly.

In short, output voltage signal S4 is virtually a continuous voltage with a value that is, typically, equivalent to half the amplitude Vcc of input voltage signal S1. The value of this output voltage S4 reduces significantly when the user's finger is placed on insulating sheet 7 opposite electrode 6. This reduction in the output voltage S4, which reflects the increased ground capacitance of equivalent capacitor C6 formed by electrode 6, is far greater than the noise and therefore it is detected reliably by receiver 1. Typically, this reduction in output voltage S4 is 300 mV when a 6 mm transparent glass ceramic plate is used as insulating sheet 7.

In order to measure output voltage S4 a microcontroller 8 is used with an analogue/digital converter, preferably with a resolution of 10 bits. Microprocessor 8 executes a processing algorithm that samples the signal with sufficient frequency, for example 10 measurements per second, registers the maximum voltage envelope value as the reference level when the finger is absent, calculates the difference between the reference level and the sampled value, and activates the corresponding variable if the value of the difference exceeds a pre-established sensitivity threshold. Microcontroller 8 can activate pulse signal S1 cyclically, maintaining it during a short period of time, for example 10 ms, and analyse output signal S4 in a synchronised manner at the end of said time period. A significant consumption reduction is obtained. For example, sampling 10 times per second, every 100 ms, produces a 90% reduction in consumption.

The circuit in Fig. 2 that has been analysed above corresponds to a negative ground layout. Alternatively, the component in Fig. 1 can be made according to a positive ground connection, as illustrated in Fig. 4. In this case, voltage clamping circuit 4 has first diode D1 connected by its anode to first capacitor C1 and by its cathode at high level Vcc of input voltage signal S1, with referenced voltage signal S3 being obtained in the anode of first diode D1. Envelope detector 5, for its part, has second diode D2 connected by its cathode to the anode of first diode D1, and second capacitor C2 and resistor R2 assembled in parallel and connected on one side to the anode of second diode D2 and on the other side to the high level Vcc of input voltage signal S1, with output voltage signal S4 being obtained in the anode of second diode D2.

Normally, microcontrollers have several input ports capable of measuring voltage analogically. Using detection components like the ones in Figs. 2 and 4, one single microcontroller is capable of controlling as many sensitive keys as there are input ports for analogically measuring voltages. However, when the number of sensitive keys is greater than the number of ports available on the microcontroller, the invention enables a matrix-based multiplexing circuit to be created in order to control all the sensitive keys with one single microcontroller, which provides a single pulse generator 2. In this case, with the component according to the invention it is possible to detect the close presence of a finger through a sheet of dielectric material 7 in a plurality of different locations corresponding to a plurality of different sensitive keys, via a plurality of detection circuits like the ones in Fig. 1 arranged in parallel and powered selectively by a single pulse generator 2 through an output port of the microcontroller. This is achieved thanks to the fact that each detection circuit has its own second diode D2, but shares second capacitor C2 and second resistor R2 with the other detection circuits.

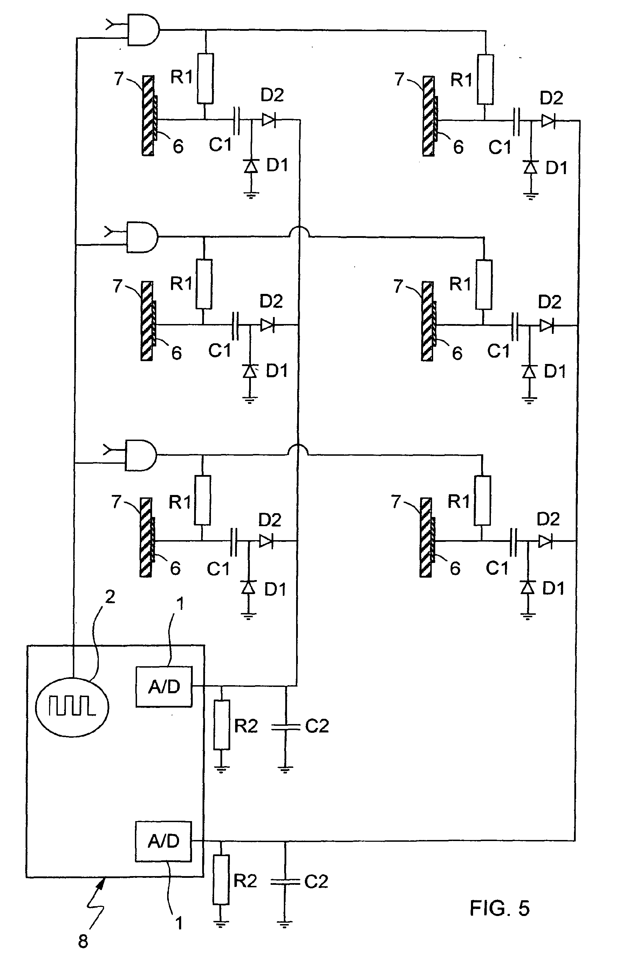

Fig. 5 shows the diagram of a circuit of this type according to the invention. In this example, there is a matrix consisting of 3 rows and 2 columns whereby it is possible to control 6 sensitive keys. A total of 3 ports on microcontroller 8 are used to select the rows, in which input voltage signal S1 is injected, and two A/D channels in said microcontroller 8 are used to measure the output voltage signal in each column. Second diode D2 in each envelope detector 5 is used as a multiplexor thanks to the fact that it blocks the passage of current to the non-selected columns and only connects to the output the cell corresponding to the selected column. Second capacitor C2 and the resistor of envelope detector 5 are shared between all the cells in a column, producing a significant reduction in the number of necessary elements. The matrix column to which the pulses from input voltage signal 1 will be applied can be selected via AND, NAND, OR, or NOR gates, governed by output ports on the same microcontroller by applying the appropriate logical levels:
- level 1 only to the column selected with AND or NAND gates;
- level 0 only to the column selected with OR or NOR gates.
Under these conditions, the gates prevent the pulse signal from being applied to the cells belonging to the non-selected columns, and they apply it to the selected ones. The response from the circuit is fast enough to guarantee an output voltage S4 that is stable for a few milliseconds after applying the pulse signal to the selected column, permitting a sufficiently fast exploration compared with the duration of the finger pulsation on the sensitive key.

Of course, this same principle can be applied to any number of rows and columns; for example, implementing a circuit similar to the one in Fig. 5, but with 8 rows and 8 columns, it is possible to control 64 sensitive keys with one single microcontroller. On the other hand, in the example in Fig. 5 a negative ground layout has been adopted similar to the one in the circuit in Fig. 2. However, the invention also comprises the case of a circuit equivalent to the one in Fig. 5, but set out according to a positive ground layout similar to the one in the circuit in Fig. 4.

## Claims

1. Detection component for a tactile screen device, suitable for detecting the close presence of a finger through a sheet of dielectric material (7), comprising a detection circuit having an electrode (6) applied to one side of said sheet of dielectric material (7), a generator (2) that provides an input voltage signal (S1), and a receiver (1) that receives an output voltage signal (S4), the detection occurring because said electrode (6) forms an equivalent capacitor (C6) and its capacitance varies when a finger approaches or is placed on the other side of said sheet of dielectric material (7), opposite electrode (6), causing said output voltage signal (S4) to vary, **characterised in that** said generator (6) is a pulse generator, said input voltage signal (S1) being a pulse signal, and said detection circuit comprises:
- a reference impedance (3) placed between said pulse generator (2) and said electrode (6), so that an attenuated pulse signal (S2) is obtained in said electrode (6) with an equivalent frequency to input voltage signal (S1) but attenuated according to a time constant that depends on the value of said variable capacitance of equivalent capacitor (C6) formed by electrode (6);
- a voltage clamping circuit (4) and a envelope detector circuit (5) placed serially between said electrode (6) and said receiver (1), so that said voltage clamping circuit (4) receives said attenuated voltage signal (S2) and shifts it in voltage to provide a referenced voltage signal (S3), and said envelope detection circuit (5) receives said referenced voltage signal (S3) and provides said output voltage signal (S4), which is virtually a continuous voltage signal with a value corresponding to the peak voltage of said referenced voltage signal (S3).

2. Component according to claim 1, **characterized in that** said voltage clamping circuit (4) is made up of a first capacitor (C1) connected to said electrode (6) and a first diode (D1) connected by its cathode to said first capacitor (C1) and by its anode to the zero level (Vo) of said input voltage signal (S1), said referenced voltage signal (S3) being obtained in the cathode of said first diode (D1).

3. Component according to claim 1, **characterized in that** said voltage clamping circuit (4) is made up of a first capacitor (C1) connected to said electrode (6) that provides said attenuated voltage signal (S2) and a first diode (D1) connected by its anode to said first capacitor (C1) and by its cathode to the high level (Vcc) of said input voltage signal (S1), said referenced voltage signal (S3) being obtained in the anode of said first diode (D1).

4. Component according to either of the claims 1 or 2, **characterized in that** said envelope detector circuit (5) is made up of a second diode (D2) connected by its anode to the output of said voltage clamping circuit (4) that provides said referenced voltage signal (S3), a second capacitor (C2) and a second resistor (R2) assembled in parallel and connected on one side to the cathode of said second diode (D2) and on the other side to the zero level (Vo) of said input voltage signal (S1), said output voltage signal (S4) being obtained in the cathode of said second diode (D2).

5. Component according to any of the claims 1 or 3, **characterized in that** said envelope detector circuit (5) is made up of a second diode (D2) connected by its cathode to the output of said voltage clamping circuit (4) that provides said referenced voltage signal (S3), a second capacitor (C2) and a resistor (R2) assembled in parallel and connected on one side to the anode of said second diode (D2) and on the other side to the high level (Vcc) of said input voltage signal (S1), said output voltage signal (S4) being obtained in the anode of said second diode (D2).

6. Component according to any of the claims 1 to 5, **characterized in that** said reference impedance (3) is a resistor (R3).

7. Component according to any of the claims 1 to 5, **characterized in that** said reference impedance (3) is a serial or parallel combination of various resistive, capacitive or inductive components.

8. Component according to any of the claims 1 to 7, **characterized in that** said pulse generator (2) that produces input voltage signal (S1) is an output port of a microcontroller (8) and said receiver (1) of output voltage signal (S4) is an input port of said microcontroller (8).

9. Component according to any of the claims 1 to 8, **characterized in that** said pulse generator (2) is activated and deactivated cyclically.

10. Component according to claim 1, suitable for detecting the close presence of a finger through a dielectric material (7) in a plurality of different locations, **characterized in that** it comprises a single pulse generator (2) and a plurality of said detection circuits arranged in parallel and powered sequentially by said pulse generator (2).

11. Component according to claims 4 and 10, **characterized in that** each of said detection circuits comprises its own second diode (D2) and shares said second capacitor (C2) and said second resistor (R2) with the other detection circuits, so that said second diode (D2) in each detection circuit performs multiplexing functions.
